# EUROPEAN PATENT APPLICATION

(11) **EP 1 852 896 A1**
(43) Date of publication of application: **07.11.2007**
(21) Application number: 06290727.4
(22) Date of filing: 05.05.2006
(51) Int. Cl.: H01L 21/20, C30B 29/04

(54) **Diamond substrate and method for fabricating the same**

(71) Applicant: Kinik Company, Taipei (TW)
(72) Inventor: Chang, Hsiao-Kuo, Taipei Taiwan (CN); Huang, Jen-Sheuan, Taipei Taiwan (CN); Teng, Chien-Chung, Taipei City Taiwan (CN); Chung, Chih-Hsien, Ying-Kuo Taipei County 239 Taiwan (CN); Wang, Ming-Hui, Ying-Kuo Taipei County 239 Taiwan (CN)
(74) Representative: Loisel, Bertrand

(57) **Abstract**

A diamond substrate and a method for fabricating the same are provided, wherein a protection layer is formed on one surface of a diamond layer in the process of forming the diamond layer by chemical vapor deposition process, for reducing the deformation of the diamond layer. Thereby the deformation of diamond substrate falls within the range of permitted tolerance of deformation, so that the performance of the diamond substrate is enhanced.

## Description

### BACKGROUND OF THE INVENTION

### Field of Invention

The present invention relates to a diamond substrate and a method for fabricating the same, and more particularly to a diamond substrate and a method for fabricating the same for reducing the deformation of the diamond layer of the diamond substrate.

### Related Art

Diamond has excellent properties, such as high light transmittance for light from deep UV light to far infrared light, high surface acoustic wave velocity, high thermal conductivity, high hardness, high radiation-resistance, good chemical inertness, and good insulation property, so that diamond has been widely applied to conventional cutting tools and abrasive tools. Recently, along with the development of the chemical vapor deposition (CVD), the application of diamond has expanded to high-frequency communication devices, heat sink and optical devices of optoelectronics, and diamond semiconductors, etc.

Due to the thermal stress between the diamond layer and the base layer generated after the CVD process, and the internal stress caused by defects within the diamond layer, fracture and deformation occur in the diamond layer. For example, though the thermal expansion coefficient of silicon is close to that of diamond, there is crystal lattice mismatch between the diamond layer and the silicon base layer. When the temperature decreases from that of the fabrication process to a low temperature, the diamond layer is deformed, even separated from the silicon base layer or fractured. Such a situation significantly affects the application of the diamond.

### SUMMARY OF THE INVENTION

In view of the above problems, the object of the present invention is to provide a diamond substrate and a method for fabricating the same, for reducing the deformation of the diamond layer of the diamond substrate, thereby substantially solving the problems in the prior art.

In order to achieve the above object, the present invention provides a diamond substrate, which includes a diamond layer and a protection layer. The protection layer is formed on one surface of the diamond film layer for preventing the diamond film layer from being deformed. The diamond substrate formed by the diamond layer and the protection layer is a diamond substrate without base layers. Moreover, the present invention further includes a base layer, formed on a lower surface of the diamond layer, and the protection layer is disposed on upper surface of the diamond layer or between the diamond layer and the base layer, thus preventing the diamond layer from being deformed.

The base layer is formed by silicon material. The diamond layer is formed by a mono-crystalline diamond or polycrystalline diamond. The protection layer is formed by hydrogen-contained diamond-like carbon, or carbides such as SiC, TiC, WC, CrC, or TiCN, or nitrides such as Si₃N₄, SiCN, TiN, BN, orTiAIN. The diamond substrate may include one or more protection layers.

Furthermore, the present invention provided a method for fabricating the diamond substrate, which includes the following steps: first, provide a base layer, and then form a diamond layer and a protection layer on the base layer, wherein the protection layer is used for preventing the diamond layer from being deformed. A diamond substrate with base layer is formed, and then a diamond substrate without base layer is obtained through the step of removing the base layer.

Moreover, in the step of forming a diamond layer and protection layer, either the protection layer is formed on the base layer before the diamond layer formed, or the diamond layer is formed on the base layer first and then a protection layer is formed, i.e., the deformation of the diamond layer can be prevented as long as the protection layer is disposed on either surface of the diamond layer.

Further scope of applicability of the present invention will become apparent from the detailed descriptions given hereinafter. However, it should be understood that the detailed descriptions and specific examples, while indicating preferred embodiments of the invention, are given by way of illustration only, since various changes and modifications within the spirit and scope of the invention will become apparent to those skilled in the art from these detailed descriptions.

### BRIEF DESCRIPTION OF THE DRAWINGS

The present invention can be fully understood from the detailed descriptions given below for illustration only, and thus are not limitative of the present invention, and wherein:
FIG.1 is a sectional view of a first embodiment of the present invention;
FIGs. 2A to 2C are schematic views for the flow chart of the method for fabricating the first embodiment of the present invention;
FIG. 3 is a sectional view of a second embodiment of the present invention;
FIG. 4 is a sectional view of a third embodiment of the present invention;
FIG. 5 is a sectional view of a fourth embodiment of the present invention;
FIGs. 6A to 6D are schematic views for the flow chart of the f method for fabricating the fourth embodiment of the present invention;
FIG. 7 is a sectional view of a fifth embodiment of the present invention; and
FIG. 8 is a sectional view of a sixth embodiment of the present invention.

### DETAILED DESCRIPTION OF THE INVENTION

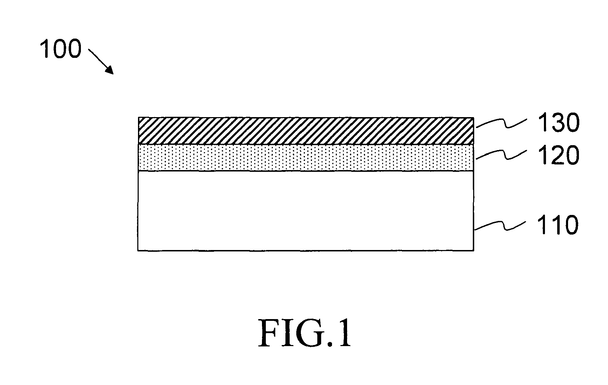

Referring to FIG. 1, a diamond substrate 100 of a first embodiment of the present invention is provided, which includes a base layer 110, a protection layer 120, and a diamond layer 130. The protection layer 120 is formed on the base layer 110, and the diamond layer 130 is formed on the protection layer 120 for preventing the diamond layer 130 from being deformed.

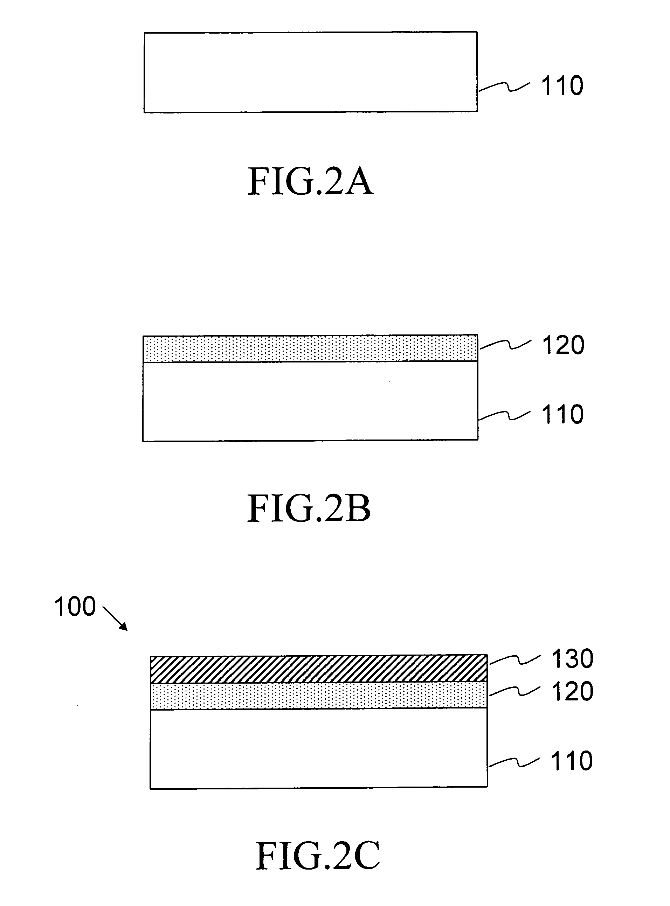

FIGs. 2A and 2C are schematic views for the flow chart of the method for fabricating the diamond substrate 100 of the first embodiment of the present invention. The method includes the following steps: first, provided a base layer 110 (FIG. 2A). Next, form a protection layer 120 on the base layer 110 (FIG. 2B). And then form a diamond layer 130 on the protection layer 120 (FIG. 2C), thus, a diamond substrate is formed.

In the present invention, the diamond substrate 100 is disk-shaped with a diameter within the range of 2 to 8 inches. The base layer 110 is formed by silicon, The thermal expansion coefficient of the diamond film layer 130 is larger than that of the base layer10, and the material of the diamond layer 130 can be mono-crystalline diamond or polycrystalline diamond. Therefore, a proper material of protection layer 120 can be selected according to the difference of the thermal expansion coefficients of the diamond layer 130 and the base layer to eliminate stresses of the diamond layer 130, protection layer 120, and base layer 100, thereby preventing the diamond substrate 100 from being deformed. For example, the thermal expansion coefficient of the base layer is larger than that of the diamond layer 130 in this embodiment to form the protection layer 120. For example, the protection layer 120 can be formed by hydrogen-contained diamond-like carbon, or carbides such as SiC, TiC, WC, CrC, or TiCN, or nitrides such as Si₃N₄, SiCN, TiN, BN, or TiAIN.

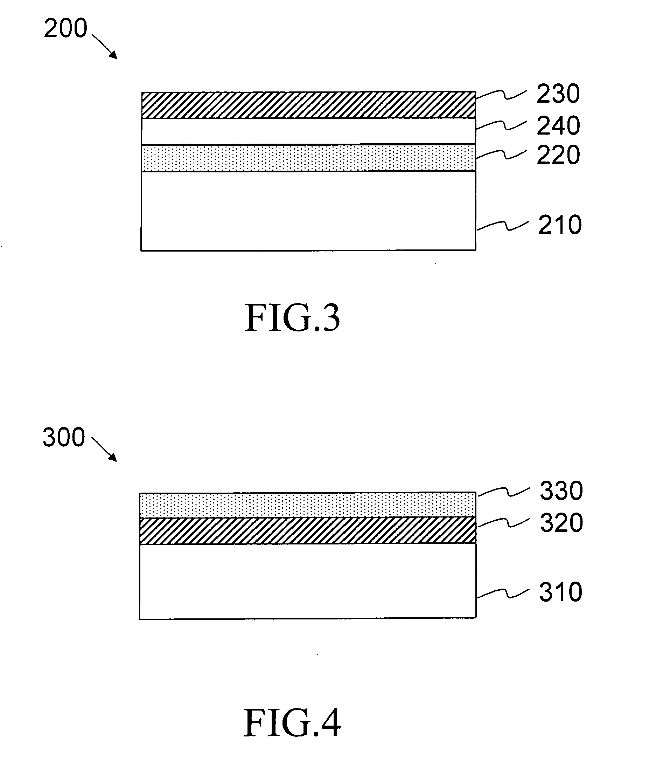

Furthermore, the diamond substrate 100 can include one or more protection layers; each of the protection layers can be formed by different materials and piled on each other. As shown in FIG. 3, a diamond substrate 200 of a second embodiment of the present invention is provided. The diamond substrate 200 includes two protection layers 220, 240 formed by different materials disposed between a diamond layer 230 and a base layer 210, for reducing the deformation of the diamond layer 230. In fact, the protection layers can be of three or four layers or more. And the material of each protection layer can be formed by the aforementioned carbides or nitrides. That is to say, the protection layers are formed by alternating between carbides and nitrides, or by alternating between different carbides, or different nitrides.

In the embodiment aforementioned, the protection layer is disposed between the diamond layer and the base layer to prevent the diamond film layer from being deformed. In fact, the same effect can be achieved whether the protection layer is disposed on the upper surface or lower surface of the diamond layer for prevent the diamond layer from being deformed.

FIG. 4 shows a diamond substrate 300 of a third embodiment of the present invention, wherein a diamond film layer 330 is disposed on a base layer 310, and a protection layer 320 is disposed on the diamond layer 330. In this embodiment, the protection layer 320 is formed by a material with a thermal expansion coefficient higher than that of the diamond film layer 330, so as to balance the stresses between the diamond film 330 and the base layer 310.

In the above embodiment, after the diamond layer and the protection layer have been formed, the step of removing the base layer is required to obtain a diamond substrate without base layer.

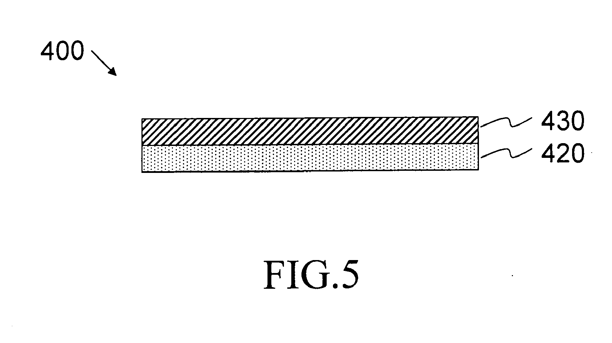

Referring to FIG. 5, a fourth embodiment of the present invention is shown. A diamond substrate 400 without a base layer only includes a diamond layer 430 and a protection layer 420, wherein the protection layer 420 is formed on the lower surface of the diamond layer 430 for reducing the deformation of the diamond layer 430.

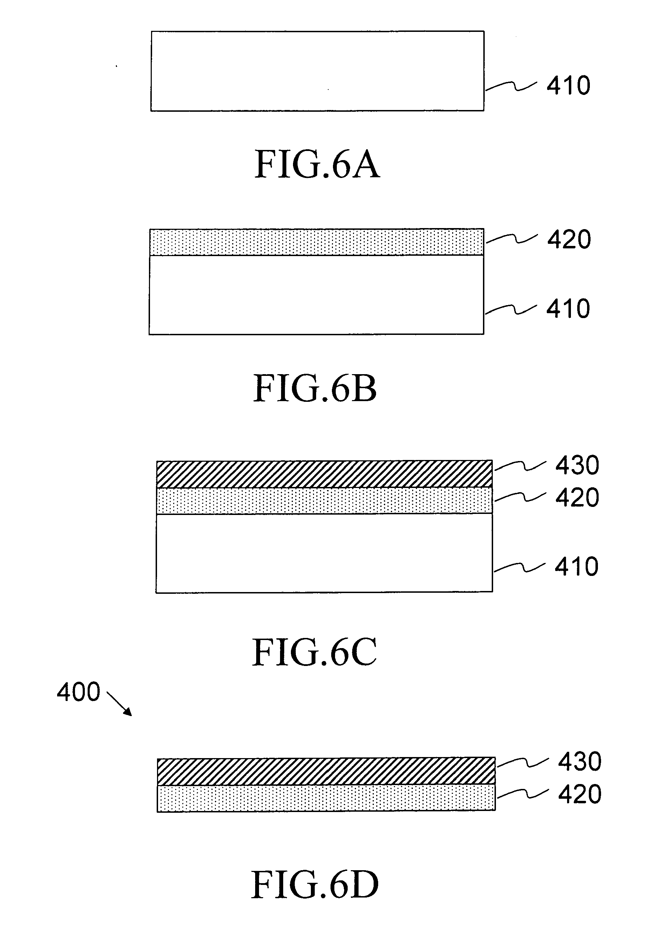

FIGs. 6A to 6D are schematic views for the flow chart of a method for fabricating a diamond substrate of a fourth embodiment of the present invention. The method includes the following steps: first, provide a base layer 410 (FIG. 6A), and then form a protection on the base layer 410 (FIG. 6B). Next, form a diamond layer 430 on the protection layer 420 (FIG. 6C). Finally, remove the base layer 410 (FIG. 6D). As such, a diamond substrate without base layer is formed.

The diamond substrate of the present invention utilizes the protection layer to reduce the deformation of the diamond layer, so as to control the deformation of the diamond substrate falls in the range of permitted deformation. Therefore, the properties for applications of the diamond substrate are enhanced, such that the characteristics of the diamond substrate can be well performed as fabricating semiconductor devices, biochemical inspection substrates, and base layers of Surface Acoustic Wave filters (SAW Filters), organic light-emitting diodes (OLEDs), inorganic LEDs, laser diodes, optical lens films, anti-radiation lens, anti-wear substrates, and cutting tools.

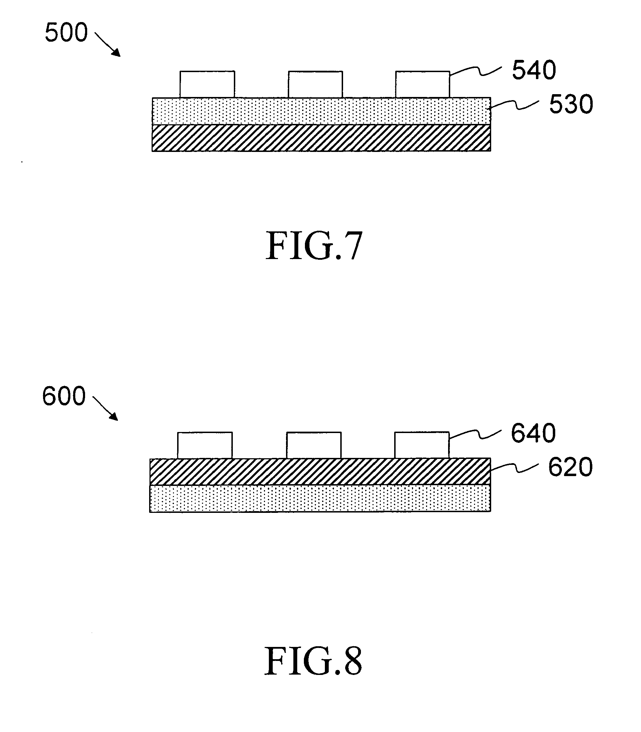

The diamond substrate may be shaped into proper configurations by laser. Since the protection layer has better chemical activity than that of the diamond layer, the diamond substrate may also be fixed onto the surface of a cutting tool or an anti-wear substrate via chemical bonding, so as to form a mechanical tool with desired cutting and anti-wear performances, or it may be jointed with other base layers. As shown in FIG. 7, in a diamond substrate 500 of a fifth embodiment of the present invention, electronic devices 540 are disposed on the upper surface of a diamond layer 530. Moreover, the electronic devices may be disposed on the upper surface of the protection layer depending upon specific requirements, so as to achieve optimal performance and adhesiveness. As shown in FIG. 8, in a diamond substrate 600 of a sixth embodiment of the present invention, electronic devices 640 are disposed on the upper surface of a protection layer 620. The aforementioned electronic devices 540 and 640 can be Surface Acoustic Wave Filter (SAW Filters), organic LEDs, inorganic LEDs, laser diodes, integrated circuits, or the like.

The invention being thus described, it will be obvious that the same may be varied in many ways. Such variations are not to be regarded as a departure from the spirit and scope of the invention, and all such modifications as would be obvious to one skilled in the art are intended to be included within the scope of the following claims.

## Claims

1. A diamond substrate, comprising:
a diamond layer; and
a protection layer, formed on one surface of the diamond layer, for preventing the diamond layer from being deformed.

2. The diamond substrate according to Claim 1, further comprising a base layer formed on a lower surface the diamond layer.

3. The diamond substrate according to Claim 2, wherein the base layer is formed by a silicon material.

4. The diamond substrate according to Claim 2, wherein the protection layer is formed on an upper surface of the diamond film layer.

5. The diamond substrate according to Claim 4, wherein the thermal expansion coefficient of the protection layer is larger than that of the diamond layer.

6. The diamond substrate according to Claim 2, wherein the protection layer is formed between the diamond layer and the base layer.

7. The diamond substrate according to Claim 6, wherein the thermal expansion coefficient of the protection layer is smaller than that of the diamond layer.

8. The diamond substrate according to Claim 1, wherein the material of the diamond layer is selected from the group consisting of mono-crystalline diamond and polycrystalline diamond.

9. The diamond substrate according to Claim 1, wherein the protection layer is formed by a hydrogen-contained diamond-like-carbon.

10. The diamond substrate according to Claim 1, wherein the protection layer is formed by carbide.

11. The diamond substrate according to Claim 10, wherein the carbide is selected from the group consisting of SiC, TiC, WC, CrC, and TiCN.

12. The diamond substrate according to Claim 1, wherein the protection layer is formed by nitride.

13. The diamond substrate according to Claim 12, wherein the nitride is selected from the group consisting of Si₃N₄, SiCN, TiN, BN, and TiAIN.

14. The diamond substrate according to Claim 1, wherein the diamond substrate comprises a plurality of protection layers.

15. The diamond substrate according to Claim 14, wherein each of the protection layers is formed by a different material and piled on each other.

16. The diamond substrate according to Claim 15, wherein each of the protection layers is formed by material selected from the group consisting of carbides and nitrides.

17. The diamond substrate according to Claim 16, wherein the carbide is selected form the group consisting of SiC, TiC, WC, CrC, and TiCN.

18. The diamond substrate according to Claim 16, wherein the nitride is selected from the group consisting of Si₃N₄, SiCN, TiN, BN, and TiAIN.

19. The diamond substrate according to Claim 1, wherein the diamond substrate is disk-shaped with a diameter within the range of 2-8 inches.

20. A method for fabricating a diamond substrate, comprising the steps of:
providing a base layer;
forming a diamond layer and a protection layer on the base layer, wherein the protection layer is used for preventing the diamond layer from being deformed; and
removing the base layer.

21. The method for fabricating a diamond substrate according to Claim 20, wherein the base layer is formed by silicon material.

22. The method for fabricating a diamond substrate according to Claim 20, wherein the steps of forming the diamond layer and the protection layer comprises:
forming the protection layer on the base layer; and
forming the diamond layer on the protection layer.

23. The method for fabricating a diamond substrate according to Claim 22, wherein the thermal expansion coefficient of the protection layer is higher than that of the diamond film.

24. The method for fabricating a diamond substrate according to Claim 20, wherein the step of forming the diamond layer and the protection layer comprises:
forming the diamond layer on the base layer; and
forming the protection layer on the diamond layer.

25. The method for fabricating a diamond substrate according to Claim 24, wherein the thermal expansion coefficient of the protection layer is lower than that of the diamond layer.

26. The method for fabricating a diamond substrate according to Claim 20, wherein the material of the diamond layer is selected from the group consisting of mono-crystalline diamond and polycrystalline diamond.

27. The method for fabricating a diamond substrate according to Claim 20, wherein the protection layer is formed by a hydrogen-contained diamond-like carbon.

28. The method for fabricating a diamond substrate according to Claim 20, wherein the protection layer is formed by carbide.

29. The method for fabricating a diamond substrate according to Claim 28, wherein the carbide is selected from the group consisting of SiC, TiC, WC, CrC, and TiCN.

30. The method for fabricating a diamond substrate according to Claim 20, wherein the protection layer is formed by nitride.

31. The method for fabricating a diamond substrate according to Claim 30, wherein the nitride is selected form the group consisting of Si₃N₄, SiCN, TiN, BN, and TiAIN.

32. The method for fabricating a diamond substrate according to Claim 20, wherein diamond substrate comprises a plurality of protection layers.

33. The method for fabricating a diamond substrate according to Claim 32, wherein each of the protection layers is formed by a different material and piled on each other.

34. The method for fabricating a diamond substrate according to Claim 33, wherein each of the protection layers is formed material selected from a group consisting of carbide and nitride.

35. The method for fabricating a diamond substrate according to Claim 34, wherein the carbide is selected from the group consisting of SiC, TiC, WC, CrC, and TiCN.

36. The method for fabricating a diamond substrate according to Claim 34, wherein the nitride is selected from the group consisting of Si₃N₄, SiCN, TiN, BN, and TiAlN.
